# EUROPEAN PATENT APPLICATION

(11) **EP 0 638 927 A1**
(43) Date of publication of application: **15.02.1995**
(21) Application number: 94305905.5
(22) Date of filing: 10.08.1994
(51) Int. Cl.: H01L 21/76, H01L 21/32

(54) **Method for manufacturing a field oxide region**

(30) Priority: 13.08.1993 US 106167
(71) Applicant: AT&T Corp., New York, NY 10013-2412 (US)
(72) Inventor: Juengling, Werner, A-8010 Graz (AT)
(74) Representative: Watts, Christopher Malcolm Kelway, Dr.

(57) **Abstract**

A method for forming channel stop implants in semiconductor integrated circuits is disclosed. Patterned polysilicon (e.g., 17, 13) and silicon nitride (e.g., 19, 15) layers are formed upon a silicon substrate (e.g., 11). Silicon dioxide spacers (e.g., 23, 25) are next formed adjacent the patterned polysilicon (e.g., 17, 13) and silicon nitride layers (e.g., 19, 15). Next, a channel stop implantation is performed (e.g., 31). The spacers (e.g., 17, 13) restrict the size of the chan stop implantation. The spacers are subsequently removed and a thermal heat treatment is performed to create the field oxides (e.g., 63). Because the width of the chan stop implants was initially restricted, subsequent lateral diffusion is not harmful.

## Description

### Technical Field

This invention relates to methods of integrated circuit fabrication.

### Background of the Invention

Typical silicon integrated circuits include many transistors which are separated from each other by a field oxide. An ion implant (generally of the same type as the tub implant if a tub process is used) is formed beneath the field oxide. The ion implant formed beneath the field oxide is often termed a channel stop or "chan stop." The chan stop implant prevents the formation of a parasitic MOS device created by runners which may overlie the field oxide. More precisely, chan stop implants raise the concentration of the tub area beneath the field oxide and thereby increase the threshold voltage of the parasitic field MOS device and also reduce the punch-through tendency of the adjacent source/drain regions of adjacent transistors.

A disadvantage of the chan stop implant is that the dopant species used to form the implant laterally diffuses into an adjacent n or p MOS device. This lateral diffusion may increase the threshold voltage of adjacent MOS devices or reduce the current drive capability of adjacent MOS devices. Unfortunately, lateral diffusion of the chan stop implant species is often a byproduct of thermal processing which is performed after the chan stop implantation is performed.

### Summary of the Invention

The undesirable lateral diffusion of the chan stop implant species is controlled by the present invention which utilizes spacers to make the initial width of the chan stop implant smaller. Illustratively, the invention includes:
forming at least one patterned layer on a substrate and then forming at least one spacer adjacent one side of the patterned layer. Then a dopant species is directed at the exposed portion of the substrate, thereby forming an implant region in the substrate. The spacer is then removed and the substrate is oxidized, thereby causing the implant region to diffuse. Then the patterned layer is removed and a transistor is formed upon the substrate. The dopant species forms the chan stop beneath the oxidized portion of the substrate. However, the initial width of the implant is narrower than in previous practice. Consequently, the subsequent diffusion of the implant species during the oxidation process does not produce any deleterious effects.

### Brief Description of the Drawings

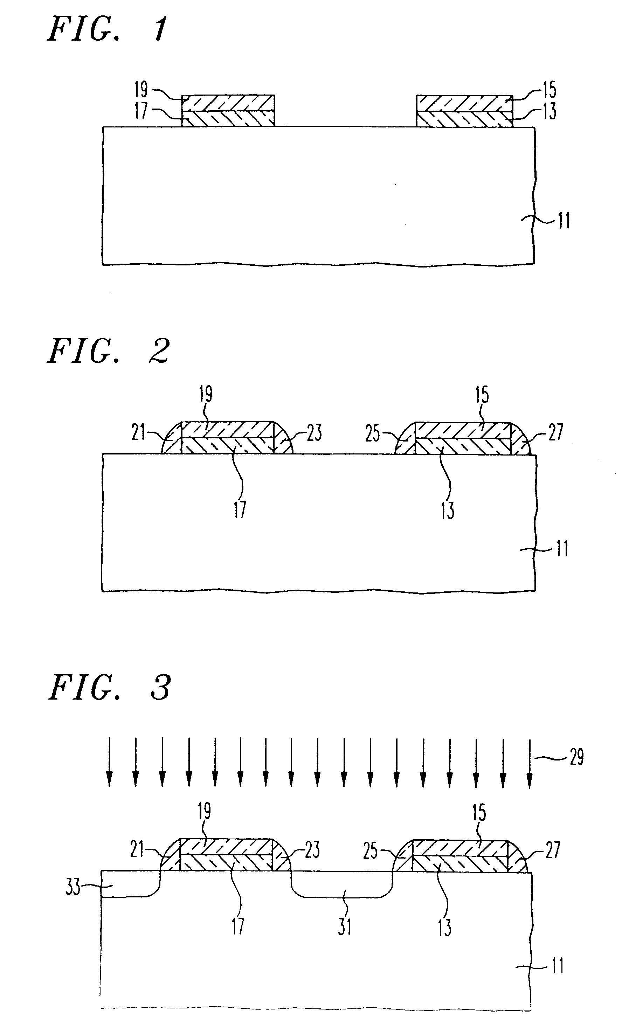

FIGS. 1-5 are cross-sectional views helpful in understanding an illustrative embodiment of the present invention.

### Detailed Description

Turning to FIG. 1, reference numeral 11 denotes a substrate which may, illustratively, be silicon, doped silicon, epitaxial silicon, etc. In general, the term substrate refers to a material or body upon which other material layers may be formed. Reference numerals 13 and 17 denote (optional) polysilicon layers, typically having a thickness of 100-700Å. Reference numerals 15 and 19 denote silicon nitride layers, typically having a thickness of 500-2000Å. In the embodiment depicted in FIG. 1, layers 13, 15, 17 and 19 have been patterned according to a typical LOCOS or poly-buffered LOCOS process.

If desired, spacers 21, 23, 25 and 27 may be made from a doped silicon dioxide formed from TEOS.

Turning to FIG. 2, spacers 21 and 23 have been formed adjacent layers 17 and 19. Similarly, spacers 25 and 27 have been formed adjacent layers 13 and 17. Spacers 21, 23, 25 and 27 may be formed by deposited and anisotropically etched oxides. Requirements for the spacer material are that it have a good etch selectivity against the top layers 15 and 19 and the substrate material 11 (which are silicon nitride and silicon in the embodiment discussed here) and good selectivity with respect to wet etching of other materials, such as silicon substrate 11, silicon nitride 15 and 17, thermally grown oxide and polysilicon layers 17 and 13. For example, spacers 21, 23, 25 and 27 may be made from the decomposition of TEOS, or plasma-enhanced TEOS.

In FIG. 3, chan stop implantation species 29 is directed at substrate 11. The implantation species 29 impinges upon exposed surfaces 35 and 37 of substrate 11, thereby creating doped regions 31 and 33 beneath surfaces 35 and 37, respectively. It will be noted that layers 19 and 17, together with spacers 21 and 23 absorb implant species 29, thereby preventing the formation of a doped region in that part of substrate 11 beneath them. Thus, doped regions 33 and 31 are narrower than in previous practice. Thus, they may be permitted to expand without adverse effects during subsequent heat treatments as explained below.

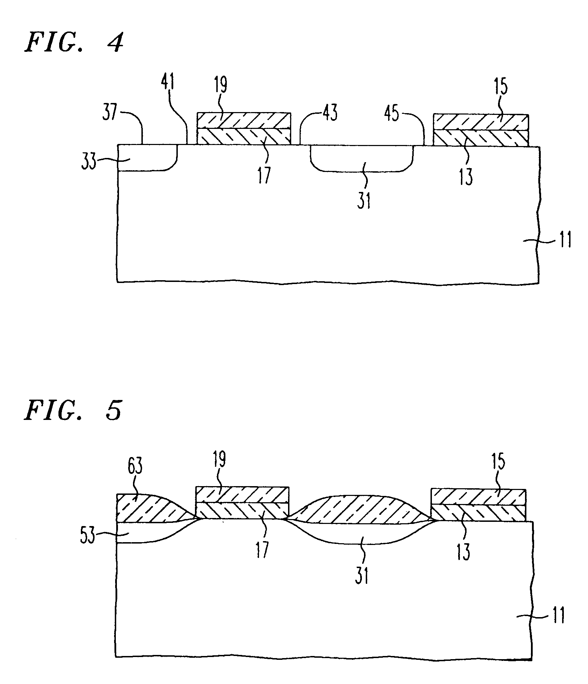

Turning to FIG. 4, spacers 21, 23, 25 and 27 have been removed, typically by wet etching.

It will be noted, as mentioned before, that those portions of silicon substrate 11, designated by reference numerals 41, 43 and 45, which were formerly covered by spacers 21, 23 and 25, do not have underlying doped channel stop regions.

In FIG. 5, an oxidation step has been performed to create field oxides 61 and 63. Typically, the oxidation step may be performed in steam or dry oxygen for a period of several hours at an elevated temperature. During the oxidation step, doped regions 31 and 33 diffuse both vertically and horizontally (i.e., laterally) thereby forming completed channel stop regions 51 and 53 depicted in FIG. 5.

Subsequent semiconductor processing may begin at this point For example, layers 17, 19, 13 and 15 may be removed and transistors formed upon the exposed portions of substrate 11. Typical MOS processing would, for example, include depositing and patterning at least an oxide and one or more conductive layers to form a gate. Spacers may be formed adjacent the gate and ion implantation performed to create source/drain regions.

The present approach permits the use of a higher channel stop implant dose and the design of narrower field oxides 61 and 63 and narrower n or p MOS devices.

## Claims

1. A method of semiconductor integrated circuit fabrication comprising:
forming at least one patterned layer (e.g., 19, 15) upon a substrate (e.g., 11); AND CHARACTERIZED BY
forming at least one spacer (e.g., 23, 25) adjacent one side of said patterned layer (e.g., 19, 15), thereby leaving a first portion of the surface of said substrate (e.g., 11) exposed;
directing a dopant species (e.g., 29) at said exposed surface of said substrate (e.g., 11), thereby forming an implant region (e.g., 31) in said substrate;
removing said spacer (e.g., 23, 25), thereby exposing a second portion (e.g., 41, 43, 45) of said substrate;
oxidizing said exposed first and second portions of said substrate (e.g., 63), thereby causing said implant region to diffuse;
removing said patterned layer (e.g., 19, 15), thereby exposing a third portion of said substrate;
forming at least one transistor upon said third portion of said substrate.

2. The method of claim 1 in which said patterned layer (e.g., 17, 13) is made from polysilicon.

3. The method of claim 1 in which said patterned layer is covered by a patterned layer made from silicon nitride (e.g., 19, 15).

4. The method of claim 1 in which said spacer (e.g., 23, 25) is made from an oxide of silicon.

5. The method of claim 1 in which said oxidizing step is a thermal oxidizing step performed in dry oxygen.

6. The method of claim 1 in which said oxidizing step is a thermal oxidizing step performed in steam.
